# EUROPEAN PATENT APPLICATION

(11) **EP 0 811 878 A1**
(43) Date of publication of application: **10.12.1997**
(21) Application number: 97201632.3
(22) Date of filing: 03.06.1997
(51) Int. Cl.: G03F 7/021

(54) **A diazo based imaging element having increased sensitivity**

(30) Priority: 06.06.1996 EP 96201581
(71) Applicant: AGFA-GEVAERT N.V., 2640 Mortsel (BE)
(72) Inventor: Vermeersch, Joan, 2640 Mortsel (BE); Kokkelenberg, Dirk, 2640 Mortsel (BE)
(74) Representative: Ramon, Charles Lucien

(57) **Abstract**

The present invention provides an imaging element comprising on a hydrophilic surface of a support a light sensitive layer comprising a diazo resin characterized in that the light sensitive layer comprises at least one diazo resin being a condensation product of 4,4' bis methoxy methyl diphenyl ether with a diazonium salt of a p-aminodiphenylamine.
The present invention also provides a method for making a lithographic printing plate comprising the steps of image-wise exposing an imaging element as defined above and subsequently developing a thus obtained image-wise exposed imaging element by means of rinsing or washing with an aqueous liquid.

## Description

### 1. Field of the invention.

The present invention relates to a diazo sensitized imaging element which is developable by plain water to a lithographic printing plate.

### 2. Background of the invention.

Lithography is the process of printing from specially prepared surfaces, some areas of which are capable of accepting lithographic ink, whereas other areas, when moistened with water, will not accept the ink. The areas which accept ink form the printing image areas and the ink-rejecting areas form the background areas.

In the art of photolithography, a photographic material is made imagewise receptive to oily or greasy inks in the photo-exposed (negative-working) or in the non-exposed areas (positive-working) on a hydrophilic background.

In the production of common lithographic printing plates, also called surface litho plates or planographic printing plates, a support that has affinity to water or obtains such affinity by chemical treatment is coated with a thin layer of a photosensitive composition. Coatings for that purpose include light-sensitive polymer layers containing diazo compounds, dichromate-sensitized hydrophilic colloids and a large variety of synthetic photopolymers.

Particularly diazo-sensitized systems are widely used. These systems have been extensively reviewed by Kosar J. in "Light-Sensitive Systems", Wiley, New York, 1965, Chapter 7. A generally used negative-working diazo-sensitized system is based on the capability of diazo compounds to harden a polymer when exposed to ultraviolet and blue radiation. Diazo compounds which have been used for the preparation of lithographic printing plates based on their hardening properties are e.g. diazonium salts whose photolysis products can harden polymers (natural colloids or synthetic resins) directly and diazonium polymers. Although polymers containing diazonium groups have a large structure they remain water soluble owing to the presence of the ionic diazonium groups. When these groups are destroyed by exposure to light an insoluble resin is formed. Particularly useful diazonium polymers are the condensation products of a carbonyl compound, e.g. an aldehyde, such as formaldehyde, with a diazonium salt of e.g. a p-aminodiphenylamine. These condensation products are usually designated diazo resins. In these systems a polymeric binder is optionally added to the diazo resin coating.

Several types of supports can be used for the manufacturing of a diazo-sensitized lithographic printing plate. Common supports are metal supports like Al or Zn, polyester film supports and paper bases. These supports, if not sufficient hydrophilic by themselves, are first coated with a hydrophilic layer to form the hydrophilic background of the printing plate and a top layer containing the diazo compound is then applied (see for example DE-P-1900469, DE-P-2030634 and US-P-3971660).

It is known to use as hydrophilic layer in these systems a layer containing polyvinyl alcohol and hydrolyzed tetraethyl orthosilicate and preferably also silicium dioxide and/or titanium dioxide as described in e.g. GB-P-1419512, FR-P-2300354, US-P-3971660 and 4284705. This hydrophilic layer is overcoated with a light-sensitive layer containing a diazonium salt or a diazo resin in a polymeric binder.

Upon image-wise exposure of the light-sensitive layer the exposed image areas become water insoluble and the unexposed areas remain water soluble. The plate is then developed with water to remove the diazonium salt or diazo resin in the unexposed areas. Such development may take place by means of plain water as disclosed in e.g. EP-A-450199 and EP-A-601240.

It has however been found that the lithographic properties of a lithographic printing plate obtained from diazo based imaging elements comprising as hydrophilic layer a layer containing a hydrophilic (co)polymer or (co)polymer mixture and hydrolyzed tetraethyl orthosilicate as disclosed in e.g. EP-A-450199; EP-A-601240 and US-P-3971660 either decrease upon storage of the imaging element or that said imaging elements have a low sensitivity.

### 3. Summary of the invention.

It is an object of the present invention to provide a diazo based imaging element comprising a support with a hydrophilic surface for producing a lithographic printing plate having an improved storage stability, a high printing endurance and an increased sensitivity.

Other objects will become apparent from the description hereinafter.

According to the present invention there is provided an imaging element comprising on a hydrophilic surface of a support at least a light sensitive layer including a cationic or nonionic aqueous dispersion of a water-insoluble polymer and a diazo resin characterized in that the light sensitive layer comprises at least one diazo resin being a condensation product of 4,4' bis methoxy methyl diphenyl ether with a diazonium salt of a p-aminodiphenylamine.

According to the present invention there is provided a method for obtaining a lithographic printing plate comprising the steps of image-wise exposing an imaging element as defined above and subsequently removing the light sensitive layer in the non-exposed or insufficiently exposed areas of said imaging element by means of rinsing or washing said imaging element with an aqueous liquid.

### 4. Detailed description

By using in the imaging element in accordance with the present invention a light sensitive layer including a cationic or nonionic aqueous dispersion of a water-insoluble polymer and at least one diazo resin being a condensation product of 4,4' bis methoxy methyl diphenyl ether with a diazonium salt of a p-aminodiphenylamine the developability and the lithographic properties such as ink repellance by the non-printing areas remain much more stable upon storage of the imaging element before imaging and the sensitivity of the imaging element is increased.

Said condensation product of 4,4' bis methoxy methyl diphenyl ether with a diazonium salt of a p-aminodiphenylamine can have any structure obtainable by electrophilic substitution of 4,4' bis methoxy methyl diphenyl ether on all the positions on the two phenyl groups which comprise a hydrogen atom.

Preferably said p-aminodiphenylamine is substituted by an alkyl or alkoxy group. More preferably said substituent comprises from 1 to 4 carbon atoms, most preferably 1 or 2 carbon atoms. Still more preferably said substituent is an alkoxy group. Particularly preferably said diazo resin comprising a diazonium salt of a p-aminodiphenylamine substituted by an alkyl or alkoxy group comprises a 3-methoxy-diphenylamine-4-diazonium group.

Preferably said diazonium salts or diazo resins comprise as anion an acid residue of phosphoric acid or sulphuric acid,

Although said diazo resin can comprises diazonium groups obtained from different p-aminodifenylamines preferably said diazo resin comprises only diazonium groups derived from one p-aminodiphenylamine and only linking groups derived from 4,4' bis methoxy methyl diphenyl ether.

Although said diazo resin can be used in admixture with a second diazo resin or a diazonium salt, preferably only one diazo resin is used , more preferably the condensation product of 4,4' bis methoxy methyl diphenyl ether with 3-methoxy-diphenylamine-4-diazonium salt.

Said diazo resins are preferably used as single compounds in the light sensitive layer but they can also be used in a mixture either of diazo resins or of (a) diazo resin(s) and (a) diazonium salt.

The light sensitive layer according to the present invention also comprises dispersed water-insoluble polymers. Said aqueous dispersion of water insoluble polymer is cationic or nonionic either e.g. as a result of an emulsifier or by having the cationic or nonionic group linked to the polymer. The water insoluble polymer is preferably a solid particulate having a size in the range of about 100 Angstroms to 1 micron in diameter and does not form a film below 30 °C. In general, any polymer which carries a cationic or nonionic group or which can be formulated into an emulsion using a cationic or nonionic emulsifier can be employed in the present invention. Suitable polymers include homopolymers and copolymers of styrene, methylacrylate, ethylacrylate, butylacrylate, methylmethacrylate, ethylmethacrylate, butyl methacrylate, vinyl acetate, vinyl chloride, vinylidene chloride, butadiene, methyl styrene, vinyl toluene, dimethylaminoethyl acrylate, acrylic acid, methacrylic acid, isoprene, chloroprene, maleic anhydride, ethylene glycol acrylates such as polyethylene glycol acrylate, halogenated vinyl aromatics such as chlorostyrene and bromostyrene, methylvinyl ether, vinyl pyrrolidone, polyurethane and the like.

Among the cationic and nonionic emulsifiers which can be used in the present invention are: ammonium salts of substituted amines containing alkyl and/or aryl groups attached to the nitrogen, alkyl or aryl sulfonium salts, alkyl and alkyl-aryl polyethers, cationic or nonionic fluorosurfactants and polyoles.

The light sensitive layer of an imaging element in connection with the present invention preferably also comprises a hydrophilic binder. Suitable hydrophilic binders are for example pullulan and hydrolyzed polyvinyl acetate.

Pullulan is a polysacharide that is produced by micro-organisms of the Aureobasidium pullulans type (Pullularia pullulans) and that comprises maltotriose repeating units connected by α-1,6 glycosidic bond. Pullulan is generally produced on industrial scale by fermentation of partially hydrolysed starch or by bacterial fermentation of sucrose. Pullulan is commmercially available from e.g. Shodex, Pharmacosmos.

Alternatively the light sensitive layer may contain polyvinylacetate hydrolysed to an extent of at least 95% by weight as a binder.

Preferably the light sensitive layer further includes a cationic fluor containing surfactant, preferably a perfluorinated surfactant and more preferably a perfluorinated ammonium surfactant. Typical examples of perfluorinated ammonium surfactants are:
n.C₈F₁₇SO₂NH-(CH₂)₃N⁺(CH₃)₃I⁻ (Fluorad FC 135 from 3M)
n.C₉F₁₉SO₂NH-(CH₂)₄N⁺(CH₃)₃Br⁻
n.C₇F₁₅CONH-(CH₂)₃N⁺(CH₃)₃I⁻
(n.C₈F₁₇COO-(CH₂)₄)₂N⁺(CH₃)₂I⁻

The thickness of the light-sensitive layer in the material of this invention may vary in the range from 0.1 to 10 µm and is preferably between 0.5 and 2.5 µm.

Said hydrophilic surface of a support can be a hardened hydrophilic layer, containing a hydrophilic binder and a hardening agent coated on a flexible support.

Suitable flexible supports that can be used in an imaging element in accordance with the present invention are e.g. photographic film bases e.g. substrated polyethylene terephthalate film, cellulose acetate film, plastics having a metal layer or deposit thereon, and polyolefin (e.g. polyethylene) coated paper, the polyolefin surface of which may have been subjected to a corona discharge to improve the adherence of a hydrophilic layer.

As hydrophilic (co)polymers in the hydrophilic layer of an imaging element in connection with the present invention one may use, for example, homopolymers and copolymers of vinyl alcohol, acrylamide, methylol acrylamide, methylol methacrylamide, hydroxyethyl acrylate or hydroxyethyl methacrylate. The hydrophilicity of the (co)polymer or (co)polymer mixture used is preferably the same as or higher than the hydrophilicity of polyvinyl acetate hydrolyzed to at least an extent of 60 percent by weight, preferably 80 percent by weight. Most preferably polyvinyl alcohol hydrolyzed to at least an extent of 80 percent by weight is used in the hydrophilic layers in connection with the present invention

Examples of hydrolyzed tetraalkyl orthosilicate crosslinking agents are hydrolyzed tetraethyl orthosilicate and hydrolyzed tetramethyl orthosilicate.

Said hydrophilic layer in an imaging element used in accordance with the present invention preferably also contain substances that increase the mechanical strength and the porosity of the layers. For this purpose colloidal silica may be used. The colloidal silica employed may be in the form of any commercially available water-dispersion of colloidal silica for example having an average particle size upto 40 nm, e.g. 20 nm. In addition inert particles of larger size than the colloidal silica can be added e.g. silica prepared according to Stöber as described in J. Colloid and Interface Sci., Vol. 26, 1968, pages 62 to 69 or alumina particles or particles having an average diameter of at least 100nm which are particles of titanium dioxide or other heavy metal oxides. By incorporating these particles the surface of the package of hydrophilic layers is given a uniform rough texture consisting of microscopic hills and valleys, which serve as storage places for water in background areas.

The thickness of a hydrophilic layer in a material according to this invention may vary in the range from 0.2 to 25 µm, preferably in the range from 1 to 10 µm.

One or more subbing layers may be coated between the support and the hydrophilic layer for use in accordance with the present invention in order to get an improved adhesion between these two layers.

A preferred subbing layer for use in connection with the present invention is a subbing layer comprising a hydrophilic binder and silica.

As hydrophilic binder in said subbing layer usually a protein, preferably gelatin may be used. Gelatin can, however, be replaced in part or integrally by synthetic, semi-synthetic, or natural polymers. Synthetic substitutes for gelatin are e.g. polyvinyl alcohol, poly-N-vinyl pyrrolidone, polyvinyl imidazole, polyvinyl pyrazole, polyacrylamide, polyacrylic acid, and derivatives thereof, in particular copolymers thereof. Natural substitutes for gelatin are e.g. other proteins such as zein, albumin and casein, cellulose, saccharides, starch, and alginates. In general, the semi-synthetic substitutes for gelatin are modified natural products e.g. gelatin derivatives obtained by conversion of gelatin with alkylating or acylating agents or by grafting of polymerizable monomers on gelatin, and cellulose derivatives such as hydroxyalkyl cellulose, carboxymethyl cellulose, phthaloyl cellulose, and cellulose sulphates.

A preferred silica in said subbing layer is a siliciumdioxide of the anionic type. The colloidal silica preferably has a surface area of at least 100 m² per gram, more preferably a surface area of at least 300 m² per gram.

The surface area of the colloidal silica is determined according to the BET-value method described by S. Brunauer, P. H. Emmett and E. Teller, J.Amer. Chem. Soc. 60, 309-312 (1938).

The silica dispersion may also comprises other substances,e.g. aluminium salts, stabilising agents,biocides etc.

Such types of silica are sold under the name KIESELSOL 100, KIESELSOL 300 and KIESELSOL 500 (KIESELSOL is a registered trade name of Farbenfabriken Bayer AG, Leverkusen, West-Germany whereby the number indicates the surface area in m² per gram).

The weight ratio of the hydrophilic binder to silica in the subbing layer is preferably less than 1. The lower limit is not very important but is preferably at least 0.2. The weight ratio of the hydrophilic binder to silica is more preferably between 0.25 and 0.5.

The coverage of said subbing layer is preferably more than 200 mg per m² but less than 750 mg per m², more preferably between 250 mg per m² and 500 mg per m².

The coating of the above defined subbing layer composition preferably proceeds from an aqueous colloidal dispersion optionally in the presence of a surface-active agent.

Said hydrophilic surface of a support may be a hydrophilic metallic support e.g. an aluminum foil.

The aluminum support of the imaging element for use in accordance with the present invention can be made of pure aluminum or of an aluminum alloy, the aluminum content of which is at least 95%. The thickness of the support usually ranges from about 0.13 to about 0.50 mm.

The preparation of aluminum or aluminum alloy foils for lithographic offset printing comprises the following steps : graining, anodizing, and optionally sealing of the foil.

Graining and anodization of the foil are necessary to obtain a lithographic printing plate that allows the production of high-quality prints in accordance with the present invention. Sealing is not necessary but may still improve the printing results. Preferably the aluminum foil has a roughness with a CLA value between 0.2 and 1.5 µm, an anodization layer with a thickness between 0.4 and 2.0 µm and is sealed with an aqueous bicarbonate solution.

According to the present invention the roughening of the aluminum foil can be performed according to the methods well known in the prior art. The surface of the aluminum substrate can be roughened either by mechanical, chemical or electrochemical graining or by a combination of these to obtain a satisfactory adhesiveness of a silver halide emulsion layer to the aluminum support and to provide a good water retention property to the areas that will form the non-printing areas on the plate surface.

The electrochemical graining process is preferred because it can form a uniform surface roughness having a large average surface area with a very fine and even grain which is commonly desired when used for lithographic printing plates.

Electrochemical graining can be conducted in a hydrochloric and/or nitric acid containing electrolyte solution using an alternating or direct current. Other aqueous solutions that can be used in the electrochemical graining are e.g. acids like H₂SO₄, H₃PO₄, that if desired, contain additionally one or more corrosion inhibitors such as Al(NO₃)₃, AlCl₃, boric acid, chromic acid, sulphates, chlorides, nitrates, monoamines, diamines, aldehydes, phosphates, H₂O₂, etc. ...

Electrochemical graining in connection with the present invention can be performed using single-phase and three-phase alternating current. The voltage applied to the aluminum plate is preferably 10-35 V. A current density of 3-150 Amp/dm² is employed for 5-240 seconds. The temperature of the electrolytic graining solution may vary from 5-50°C. Electrochemical graining is carried out preferably with an alternating current from 10 Hz to 300 Hz.

The roughening is preferably preceded by a degreasing treatment mainly for removing greasy substances from the surface of the aluminum foil.

Therefore the aluminum foil may be subjected to a degreasing treatment with a surfactant and/or an aqueous alkaline solution.

Preferably roughening is followed by a chemical etching step using an aqueous solution containing an acid. The chemical etching is preferably carried out at a temperature of at least 30°C more preferably at least 40°C and most preferably at least 50°C.

Suitable acids for use in the aqueous etch solution are preferably inorganic acids and most preferably strong acids. The total amount of acid in the aqueous etch solution is preferably at least 150g/l. The duration of chemical etching is preferably between 3s and 5min.

After roughening and optional chemical etching the aluminum foil is anodized which may be carried out as follows.

An electric current is passed through the grained aluminum foil immersed as an anode in a solution containing sulphuric acid, phosphoric acid, oxalic acid, chromic acid or organic acids such as sulphamic, benzosulphonic acid, etc. or mixtures thereof. An electrolyte concentration from 1 to 70 % by weight can be used within a temperature range from 0-70°C. The anodic current density may vary from 1-50 A/dm² and a voltage within the range 1-100 V to obtain an anodized film weight of 1-8 g/m² Al₂O₃.H₂O. The anodized aluminum foil may subsequently be rinsed with demineralised water within a temperature range of 10-80°C.

After the anodizing step sealing may be applied to the anodic surface. Sealing of the pores of the aluminum oxide layer formed by anodization is a technique known to those skilled in the art of aluminum anodization. This technique has been described in e.g. the "Belgisch-Nederlands tijdschrift voor Oppervlaktetechnieken van materialen", 24ste jaargang/januari 1980, under the title "Sealing-kwaliteit en sealing-controle van geanodiseerd Aluminum". Different types of sealing of the porous anodized aluminum surface exist.

Preferably, said sealing is performed by treating a grained and anodized aluminum support with an aqueous solution containing a bicarbonate as disclosed in EP-A 567178, which therefor is incorporated herein by reference.

Preferably each of the above described steps is separated by a rinsing step to avoid contamination of the liquid used in a particular step with that of the preceding step.

According to a preferred embodiment in connection with the present invention there is provided an intermediate layer of an organic compound having cationic groups between the hydrophilic surface of a support and the light sensitive layer. As a consequence the development by plain water of such a diazo based imaging element is improved.

Organic compounds having cationic groups for use in an intermediate layer are preferably hydrophilic and may be low moleculair weight compounds but are preferably polymers. Preferred compounds are those having one or more ammonium groups or amino groups that can be converted to ammonium groups in an acidic medium. An especially preferred type of cationic compounds are polysacharides modified with one or more groups containing an ammonium or amino group.

Most preferred organic compounds having cationic groups are dextrans or pullulan wherein at least some of the hydroxy groups of the dextran or pullulan has been modified into one or more of the following groups:

-O-R¹ -O-CO-R²

wherein R¹ represents an organic residue containing an amino or ammonium group, e.g. an amine substituted alkyl, an amine substituted alkylaryl etc..
R² has one of the significances given for R¹ or stands for -OR³ or -N(R⁴)R⁵, wherein R³ has one of the significances given for R¹ and each of R⁴ and R⁵ which may be the same or different have one of the significances given for R¹.

Examples of dextrans or pullulan that can be used in accordance with the present invention are dextrans or pullulan wherein some of the hydroxyl groups have been modified in one of the groups shown in table 1.

**Table 1**

| no. | modified group |
|---|---|
| 1 | -O-CH₂-CH₂-NH₂ |
| 2 | -O-CO-NH-CH₂-CH₂-NH₂ |
| 3 | -O-CO-NH-CH₂-CH₂-N(CH₂-CH₂-NH₂)₂ |
| 4 | -O-CH₂-CH₂-NH-CH₂-CH₂-NH₂ |
| 5 | -O-CH₂-CH₂-NH-CH₂-CHOH-CH₂-N⁺(CH₃)₃ Cl⁻ |
| 6 | -O-(CH₂-CH₂-O)ₙ-CH₂-CH₂-NH₂ |
| wherein n represents an integer from 1 to 50 | |
| 7 | -O-CO-NH-CH₂-CH₂-NH-CH₂-CHOH-CH₂-N⁺(CH₃)₃ Cl⁻ |
| 8 | -O-CH₂-CH₂-N(CH₂-CH₃)₂ .HCl |
| 9 | -O-CH₂-CH₂-N(CH₂-CH₂-NH₂)₂ |
| 10 | -O-CONH-CH₂-CH₂-N(CH₂-CH₂-NH₂)₂ |
| 11 | -O-CONH-(CH₂-CH₂-O)ₙ-CH₂-CH₂-NH₂ |

The modified dextrans or pullulan can be prepared by a reaction of a dextran with e.g. alkylating agents, chloroformates, acid halides, carboxylic acids etc...

An intermediate layer comprising the organic compound having one or more cationic groups is preferably provided in an amount of 5 to 500 mg/m² and more preferably in an amount of 10 to 200 mg/m².

The imaging element in connection with the present invention advantageously comprises water-soluble dyes such as rhodamines, sudan blue, methylen blue, eosin or trifenylmethane dyes such as crystal violet, victoria pure blue, malachite green, methylviolet and fuchsin or dye pigments. These colorants may be incorporated in the light sensitive layer and/or hardened hydrophilic layers.

To obtain a lithographic printing plate from an imaging element according to the invention said imaging element is image-wise exposed and subsequently rinsed or washed with an aqueous liquid, preferably plain water to remove the diazo resin(s) and optionally the diazonium salt(s) in the non-exposed or insufficiently exposed parts of the imaging element.

The exposure of the imaging element used in the present invention advantageously proceeds with ultraviolet light optionally in combination with blue light in the wavelength range of 250 to 500 nm. Useful exposure sources are high or medium pressure halogen mercury vapour lamps, e.g. of 1000 W. Since most lithography is done by the offset process, the imaging element is preferably exposed in such a way that the image obtained thereon is right reading. The exposure may be an exposure using optics or a contact exposure.

The diazo resin(s) and optionally the diazonium salt(s) are converted upon exposure from water soluble to water insoluble (due to the destruction of the diazonium groups) and additionally the photolysis products of the diazo may induce an advancement in the level of crosslinking of the polymeric binder or diazo resin, thereby selectively converting the surface, in an image pattern, from water soluble to water insoluble. The unexposed areas remain unchanged, i.e. water soluble.

The following examples illustrate the present invention without being limited thereto. The percentages given are by weight unless otherwise stated.

### EXAMPLE 1

### Preparation of a lithographic base

To 440 g of a dispersion contg. 21.5% TiO₂ (average particle size 0.3 to 0.5 um) and 2.5% polyvinyl alcohol in deionized water were subsequently added, while stirring, 250 g of a 5% polyvinyl alcohol solution in water, 105 g of a hydrolyzed 22% tetramethylorthosilicate emulsion in water and 12 g of a 10% solution of a wetting agent.
To this mixture was added 193 g of deionized water and the pH was adjusted to pH=4.

The obtained dispersion was coated on a polyethylene terephthalate film support having a thickness of 175 µm (coated with a hydrophilic adhesion layer) to a wet coating thickness of 50 g/m², dried at 30 °C. and subsequently hardened by subjecting it to a temperature of 57 °C for 1 week.

To this base was further provided an aqueous solution (pH=5) of Dormacid (a dextran modified with a diethylaminoethylgroup available from Pfeifer & Langen) and a cationic wetting agent to a dry coating thickness of 30 mg Dormacid per m².

The obtained element was then heated for 1 week at 57 °C.

### Preparation of the imaging elements

### Preparation of the light sensitive coating:

To 63g of a 20% dispersion of polymethylmethacrylate (particle diameter of 40nm) stabilized with cetyltrimethylammoniumbromide in deionized water was subsequently added, while stirring, 120 g of a 5% solution of a 98% hydrolysed polyvinyl acetate (POLYVIOL W48/20 available from Wacker) in water and 15 g of a 10% dispersion of HELIOGEN BLUE (BASF) in water. 66 g of a 15% solution of the diazo resin I (the condensation product of 3-methoxy-diphenylamine-4-diazonium dihydrogen phosphate with 4,4' bis methoxy methyl diphenyl ether, sold by HAKEI) was then slowly added. Finally 30 g of a 1.6% solution of cationic fluor containing surfactant (Fluorad FC135 available from 3M) in water, and 726 ml of water were added.

The imaging element 1 was produced by coating the above described light sensitive composition to the above described lithographic base in an amount of 35g/m² (wet coating amount) and drying it at 30°C.

Imaging elements 2, 3 and 4 were prepared in an identical way as imaging element 1 with the exception that the diazo resin I was replaced in imaging element 2 by diazo resin II (the condensation product of 3-methoxy-diphenylamine-4-diazonium hydrogensulfate salt and formaldehyde, sold by Fairmount), in imaging element 3 by diazo resin III (the condensation product of diphenylamine-4-diazonium dihydrogenphosphate and formaldehyde) and in imaging element 4 by diazo resin IV (the condensation product of diphenylamine-4-diazonium hydrogensulfate salt and formaldehyde).

The obtained imaging elements were conditioned at 25°C at 40% relative humidity for 24 hours and under these conditions packaged in a closed aluminium bag being impermeable for water. The packages were then stored for various times at 57°C.

The imaging elements were each exposed to a high pressure halogen mercury vapour lamp of 1000W at a distance of 70cm for the time necessary to obtain 2 solid steps after development.

Subsequently the imaging elements were developed by wash-off with plain water in an Agfa HWP 450 deyeloping machine. The obtained printing plates thus prepared were mounted on an offset printing machine (AB Dick 360- trade name for an offset printing machine manufactured by AB Dick Co) equiped with a Varn Compac II dampening system. During the printing run a commercial dampening solution and Van Son rubberbase RB 2329 ink were used. The obtained results are shown in table 2.

**Table 2**

| Material^{a)} | Storage I^{b)} | Storage II^{c)} | Sensitivity^{d)} |
|---|---|---|---|
| 1 | 3 days | 2.5 days | 45 sec |
| 2 | 3 days | 2.5 days | 180 sec |
| 3 | 2 days | 1 day | 90 sec |
| 4 | 2 days | 1 day | 75 sec |

| | | | |
|---|---|---|---|
| a) Material : The composition of the different materials is given in the text. | | | |
| b) Storage I : maximum storage time whereby the photosensitive layer is still removed by development from the plate in the non-image areas. | | | |
| c) Storage II : maximum storage time allowing toning free printing. | | | |
| d) Sensitivity : the time necessary to obtain 2 solid steps after development. | | | |

### Evaluation:

It is clear that imaging elements 2 (comparative element) shows a good storage stability indeed, yet a very low sensitivity. The imaging elements 3 and 4 (comparative elements) show a reasonable sensitivity indeed, yet a low stability while imaging element 1 (imaging element according to the invention) shows at the same time a good storage stability and a very high sensitivity.

## Claims

1. An imaging element comprising on a hydrophilic surface of a support at least a light sensitive layer including a cationic or nonionic aqueous dispersion of a water-insoluble polymer and a diazo resin characterized in that the light sensitive layer comprises at least one diazo resin being a condensation product of 4,4' bis methoxy methyl diphenyl ether with a diazonium salt of a p-aminodiphenylamine.

2. An imaging element according to claim 1 wherein said p-aminodiphenylamine is substituted by an alkyl or alkoxy group.

3. An imaging element according to claim 2 wherein said substituent comprises 1 or 2 carbon atoms.

4. An imaging element according to claim 2 wherein said diazo resin comprising a diazonium salt of p-aminodiphenylamine substituted by an alkyl or alkoxy group comprises a 3-methoxy-diphenylamine-4-diazonium group.

5. An imaging element according to any of the claims 1 to 4 wherein said diazo resin comprising a diazonium salt of p-aminodiphenylamine comprises as anion an acid residue of phosphoric acid or sulphuric acid.

6. An imaging element according to any of the claims 1 to 5 wherein there is provided an intermediate layer comprising an organic compound having cationic groups between said hydrophilic surface and said light sensitive layer.

7. An imaging element according to any of the claims 1 to 6 wherein said light sensitive layer comprises a polyvinylacetate hydrolysed to an extent of at least 95% by weight as a hydrophilic binder and further a cationic fluor containing surfactant.

8. An imaging element according to any of the claims 1 to 7 wherein said hydrophilic surface of a support is a hardened hydrophilic layer, containing a hydrophilic binder and a hardening agent coated on a flexible support.

9. An imaging element according to any of the claims 1 to 7 wherein said hydrophilic surface of a support is the hydrophilic surface of a metallic support.

10. A method for making a lithographic printing plate comprising the steps of image-wise exposing an imaging element as defined in any of the claims 1 to 9 and subsequently developing a thus obtained image-wise exposed imaging element by rinsing or washing with an aqueous liquid.
